(19) Europäisches Patentamt
European Patent Office
Office européen des brevets

(11) **EP 2 569 827 B1**

(12) **EUROPÄISCHE PATENTSCHRIFT**

(45) Veröffentlichungstag und Bekanntmachung des Hinweises auf die Patenterteilung:
**22.06.2016 Patentblatt 2016/25**

(51) Int Cl.:
***H01R 9/26*** *(2006.01)*      ***H01R 12/72*** *(2011.01)*
***H05K 7/14*** *(2006.01)*      *H01R 9/24* *(2006.01)*

(21) Anmeldenummer: **11718701.3**

(22) Anmeldetag: **02.05.2011**

(86) Internationale Anmeldenummer:
**PCT/EP2011/056953**

(87) Internationale Veröffentlichungsnummer:
**WO 2011/141314 (17.11.2011 Gazette 2011/46)**

(54) **TRAGSCHIENENBUSSYSTEM**

SUPPORTING RAIL BUS SYSTEM

SYSTÈME DE BUS AVEC RAIL DE SUPPORT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.05.2010 DE 102010016865**

(43) Veröffentlichungstag der Anmeldung:
**20.03.2013 Patentblatt 2013/12**

(73) Patentinhaber: **Weidmüller Interface GmbH & Co. KG**
**32758 Detmold (DE)**

(72) Erfinder:
• **GRIESE, Björn**
  **33102 Paderborn (DE)**
• **LANGE, Stephan**
  **32657 Lemgo (DE)**

• **BÖCKER, Marc**
  **32839 Steinheim (DE)**
• **KRONER, Michael**
  **33813 Oerlinghausen (DE)**
• **SCHNÜCKEL, Markus**
  **32758 Detmold (DE)**
• **ROSE, Gorm**
  **33100 Paderborn (DE)**

(74) Vertreter: **Specht, Peter**
**Loesenbeck - Specht - Dantz**
**Patent- und Rechtsanwälte**
**Am Zwinger 2**
**33602 Bielefeld (DE)**

(56) Entgegenhaltungen:
**EP-A1- 0 661 915       WO-A1-00/13264**
**DE-A1-102007 006 830    DE-C1- 4 438 801**
**DE-U1- 29 713 960**

**Beschreibung**

Die Erfindung betrifft ein Tragschienenbussystem nach dem Oberbegriff des Anspruchs 1.

Derartige Tragschienenbussysteme weisen eine Tragschiene auf, auf welche reihenklemmenartig aneinander reihbare Module, die auch als Busteilnehmer bezeichnet werden, aufsetzbar sind, und einen in der Tragschiene angeordneten Stationsbus, mit dem die Module untereinander und vorzugsweise auch mit einer Steuerung oder einem Gateway verbindbar sind. Die Module weisen vorzugsweise jeweils eine eigene Elektronik auf, welche an den Modulbus angeschlossen ist und dienen in der Regel zum Anschluss von Feldgeräten wie Aktoren, Sensoren oder Initiatoren.

Der Stationsbus versorgt die Module mit elektrischer Energie und überträgt Daten- und/oder Steuersignale an die Module, von den Modulen oder zwischen diesen.

Der kontinuierlich steigende Bedarf in der Steuerungstechnik, z.B. in der Automatisierungstechnik führt zu der Forderung nach Tragschienenbussystemen, die hinsichtlich der Teilezahl, Teilnehmerzahl und einer kompakten Bauweise weiter optimiert sind.

DE 297 13 960 U1 offerbart einen Tragschienenbussystem nach dem Oberbegriff des Anspruchs 1.

Die Aufgabe der vorliegenden Erfindung besteht daher darin, ein verbessertes Tragschienenbussystem zu schaffen.

Die Aufgabe wird durch ein Tragschienenbussystem mit den Merkmalen des Anspruchs 1 gelöst.

Jedes Busglied weist Kontaktstifte zur Übertragung und/oder Manipulation elektrischer Versorgungsleistung und/oder mindestens eine Leiterplatte mit Leiterbahnen zur Übertragung elektrischer Daten- und/oder Steuersignale mit vorzugsweise geringerer Leistung als die Versorgungsleistung auf. Dabei sind jeder Kontaktstift und jede Leiterbahn der Leiterplatte jeweils mit jeweils einem Doppel-Buchsenkontaktelement verbunden. Alle Doppel-Buchsenkontaktelemente sind insbesondere gleich ausgebildet und können sowohl für Leistungsübertragung als auch für Datenübertragung benutzt werden, was zu einer geringen Teilevielfalt führt und die Kosten zur Herstellung des Systems senkt.

Ein weiterer Vorteil besteht darin, dass die Doppel-Buchsenkontaktelemente sowohl zur Übertragung elektrischer Versorgungsleistung als auch zur Übertragung elektrischer Daten- und/oder Steuersignale geringerer Leistung ausgebildet sind. Deshalb sind sie sowohl zur Verbindung der Kontaktstifte und Leiterbahnen als auch zum elektrischen Anschluss eines zuzuordnenden Moduls als Busteilnehmer verwendbar. Damit wird Bauraum eingespart. Eine kompakte Bauweise ergibt sich auch dadurch, wenn die zweiten Buchsenabschnitte des Doppel-Buchsenkontaktelementes im Wesentlichen senkrecht zu den ersten Buchsenabschnitten, die sich in Längsrichtung der Tragschiene erstrecken, angeordnet sind.

Das Doppel-Buchsenkontaktelement kann zum Beispiel als Stanzbiegeteil ausgebildet sein. Nach der Erfindung weist das Doppel-Buchsenkontaktelement einen Fuß und eine dem Fuß gegenüberliegend angeordnete Verbindungsfläche auf. Damit ist eine Anbringungsmöglichkeit sowohl an einem Kontaktstift als auch an einer Leiterplatte geschaffen, so dass keine zusätzlichen Anpassungsmaßnahmen erforderlich sind.

Eine weitere kompakte Bauweise ergibt sich aufgrund der nebeneinander anzuordnenden Doppel-Buchsenkontaktelemente, wobei sich die Kontaktstifte und die Leiterplatte in jedem Busglied nebeneinander angeordnet in Längsrichtung der Tragschiene erstrecken.

In einer weiteren Ausgestaltung, ist der Stationsbus vorzugsweise aber nicht unbedingt auch als Tragschienenbussystem ausgebildet. Das Adressierverfahren ist vielmehr auch für andere Bussysteme mit mehreren Busteilnehmern nutzbar.

Die Adressenelemente können auch zur digitalen Manipulation eines Signals ausgebildet sein, z.B. Frequenzverdoppelung, Impulspausenverhältnisänderung und so weiter. Bevorzugt dabei ist, dass die Adressenelemente als Frequenzteilereinrichtung mit einem festlegbaren, bevorzugt konstanten, Teilerfaktor ausgebildet sein. Dabei wird zum Beispiel ein digitales Signal, z.B. ein digitales Rechtecksignal, mit einer konstanten Frequenz, das von einem Frequenzgenerator erzeugt wird, auf die Adressenelemente, die in Reihe geschaltet sind, gegeben. Jedes Busglied beeinflusst dieses Signal in einer Weise, welche die Gesamtanzahl beeinflussender Busglieder erkennen lässt. Besonders vorteilhaft dabei ist die digitale Auswertbarkeit durch einen digitalen Mikrokontroller und die damit verbundene hohe Störsicherheit. Auch ist die Anzahl der Busglieder nur durch eine für die Adressenerkennung spezifizierte Zeit begrenzt. Es ist zum Beispiel ein Teilerfaktor von 2 bevorzugt.

Die Erfindung betrifft auch ein Verfahren zum Adressieren von Busgliedern eines Bussystems, bei dem das Adressieren mit einem oben beschriebenen Tragschienenbussystem erfolgt.

Die Erfindung betrifft ferner ein Verfahren zum Signalisieren eines Sammelfehlers in einem oben beschriebenen Tragschienenbussystem

Außerdem kann die beschriebene Adressleitung (analog wie auch digital) zur Signalisierung eines Sammelfehlers genutzt werden. Geeignete Verfahren hierzu sind bei resistiver Adressierung beispielhaft periodisches Kurzschließen des Adresssignals gegen eine Rückleitung. Dieses periodische Signal setzt sich dann als Spannungsänderung in allen Busgliedern fort. Bei einer digitalen Adressierung erfolgt die Fehlermeldung durch Kurzschließen des Digitalsignals durch einen Busteilnehmer. Die Busglieder stellen sicher, dass dieser Kurzschluss in beide Richtungen weitergegeben und somit kein Adressierungssignal mehr erzeugt wird.

Anhand einer beispielhaften Ausführung wird die Erfindung mit Bezug auf die beigefügten Zeichnungen näher erläutert. Hierbei zeigen:

Figur 1    eine perspektivische Darstellung eines Ausführungsbeispiels eines erfindungsgemäßen Tragschienenbussystems;

Figur 2    eine perspektivische Ansicht zweier verbundener Busglieder des erfindungsgemäßen Tragschienenbussystems nach Figur 1;

Figur 3    die zwei Busglieder nach Figur 2 in nicht verbundener Stellung;

Figur 4    eine perspektivische, teilweise offene Ansicht der verbundenen Busglieder nach Figur 2;

Figur 5    eine perspektivische Darstellung eines Busgliedleiteraufbaus eines Busglieds nach Figur 2;

Figur 6    eine perspektivische Darstellung eines Kontaktstifts mit einem DoppelBuchsenkontaktelement;

Figur 7    eine perspektivische Darstellung des Doppel-Buchsenkontaktelementes nach Figur 6;

Figur 8    eine Blockdarstellung eines Stationsbusses mit Modulen;

Figur 9    die Blockdarstellung des Stationsbusses mit Modulen nach Figur 8 mit Spannungsangaben;

Figur 10   ein Schaltbild einer Adressiereinrichtung des Stationsbusses mit Modulen nach Figur 8;

Figur 11   eine perspektivische Darstellung des Busgliedleiteraufbaus nach Figur 5 mit einem Bestandteil der Adressiereinrichtung nach Figur 10;

Figur 11a  ein Schaltbild des Bestandteils der Adressiereinrichtung des Busgliedleiteraufbaus nach Figur 11;

Figur 12   eine perspektivische, teilweise offene Ansicht der verbundenen Busglieder nach Figur 4 mit dem Busgliedleiteraufbau nach Figur 10; und

Figur 13   ein Schaltbild einer weiteren Adressiereinrichtung des Stationsbusses mit Modulen nach Figur 8.

Funktionseinheiten und Bauelemente mit gleichen Bezugszeichen weisen gleiche oder ähnliche Funktionen auf.

Die nachfolgende Erläuterung betrifft ein besonders bevorzugtes Ausführungsbeispiel, auf welches die Erfindung aber nicht beschränkt ist.

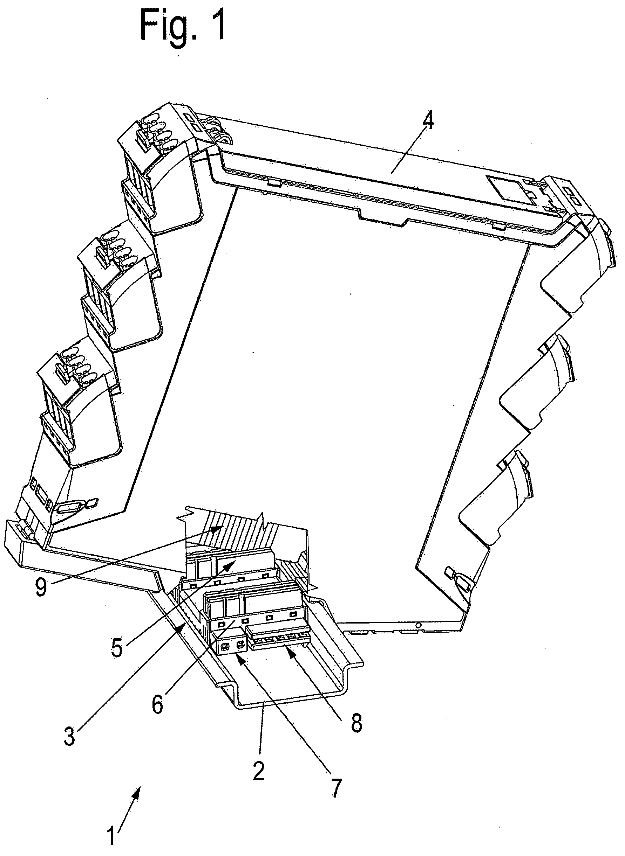

Eine perspektivische Darstellung eines Ausführungsbeispiels eines erfindungsgemäßen Tragschienenbussystems 1 ist in Figur 1 gezeigt.

Das Tragschienenbussystem 1 umfasst eine Tragschiene 2, die hier als so genannte Hutschiene ausgebildet ist und einen Stationsbus 3 mit mindestens zwei untereinander verbundenen Busgliedern 6 aufweist. Auf die Busglieder bzw. in diese ist jeweils ein Modul 4, welches hier verschiedene Leiteranschlüsse (z.B. Klemmenanschlüsse) und nicht näher erläuterte elektronische Schaltungsfunktionen aufweist, aufsteckbar oder einsteckbar und mit den Busgliedern verbindbar. Das Modul 4 wird auch als Busteilnehmer des Stationsbusses 3 bezeichnet.

Die Busglieder 6 sind innerhalb der Tragschiene 2 angeordnet, zum Beispiel kraftschlüssig gehalten oder geklemmt, und besitzen jeweils einen im Wesentlichen senkrecht zur Tragschiene 2 stehenden Steckplatz 5, welcher zum Einstecken eines Modulsteckabschnitts 9 des Moduls 4 vorgesehen ist. In der Figur 1 ist das Modul 4 in einer Stellung gezeigt, in der es mit seiner Unterseite schon an der Tragschiene 2 in Eingriff steht und der Modulsteckabschnitt 9 in den Steckplatz 5 teilweise eingeführt ist. Die Busglieder 6 sind untereinander über Steckverbindungen verbunden, von denen hier am vorderen Busglied 6 eine Leistungsbuchsenaufnahme 7 und eine Datenbuchsenaufnahme 8 zu sehen sind. Dies wird unten noch näher erläutert.

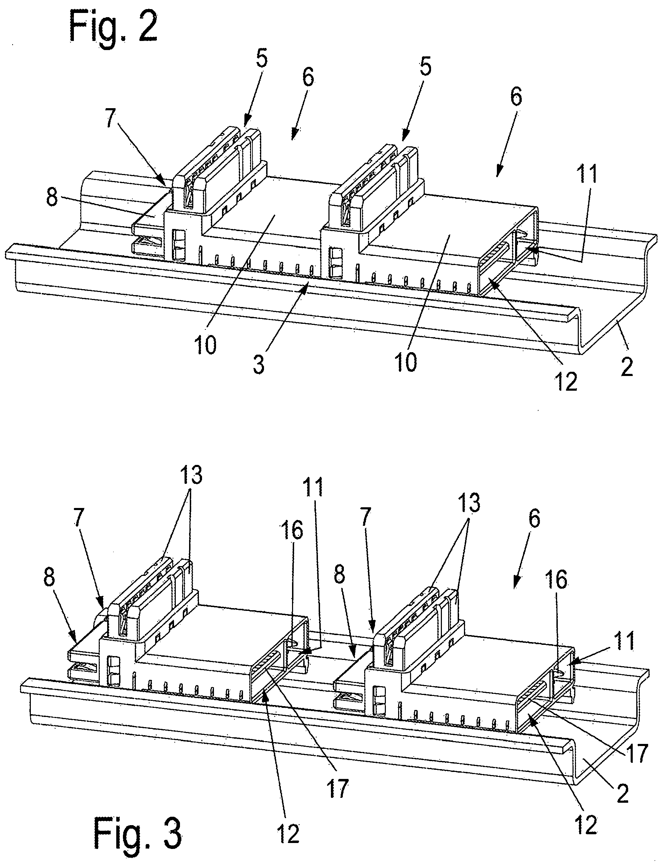

Figur 2 zeigt eine perspektivische Ansicht zweier verbundener Busglieder des erfindungsgemäßen Tragschienenbussystems 1 nach Figur 1, und Figur 3 stellt die zwei Busglieder nach Figur 2 in nicht verbundener Stellung dar.

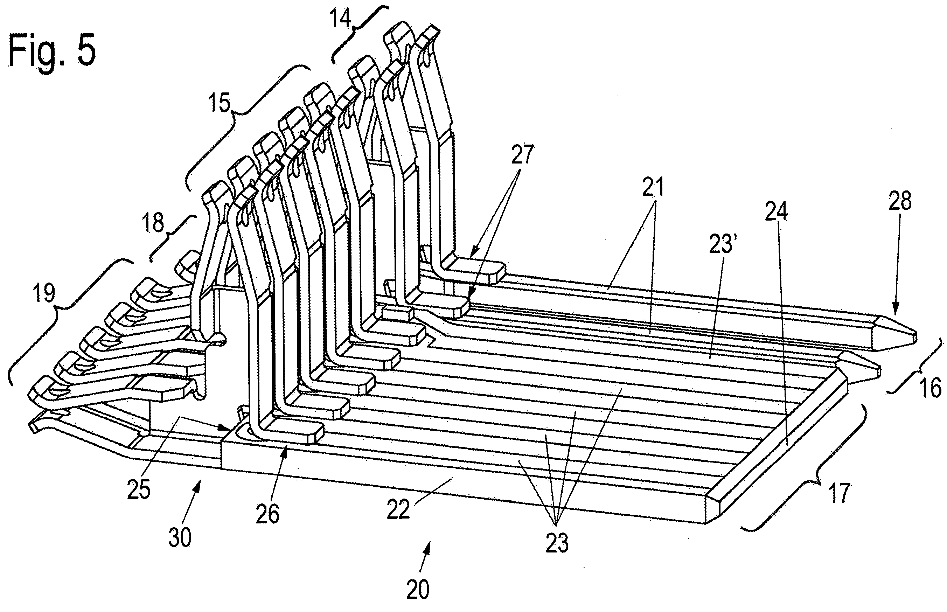

Die Busglieder 6 sind in Längsrichtung der Tragschiene 2 zusammensteckbar und untereinander verbindbar. In diesem gezeigten Beispiel weist jedes Busglied 6 ein Gehäuse 10 mit einer Leistungsbuchsenaufnahme 7 (hier auf der linken Seite) und einer Datenbuchsenaufnahme 8 und auf der gegenüberliegenden Seite (hier rechts) eine Leistungssteckeraufnahme 11 und eine Datensteckeraufnahme 12 auf. In nicht dargestellten Ausführungen kann jedes Busglied 6 entweder ein Gehäuse 10 nur mit einer Leistungsbuchsenaufnahme 7 und einer Leistungssteckeraufnahme 11 oder ein Gehäuse 10 nur mit einer Datenbuchsenaufnahme 8 und einer Datensteckeraufnahme 12 aufweisen. Die Leistungsbuchsenaufnahme 7 des linken Busgliedes 6 korrespondiert mit der gegenüberliegenden Leistungssteckeraufnahme 11 des rechten Busgliedes 6 und die Datenbuchsenaufnahme 8 des linken Busgliedes 6 korrespondiert mit der Datensteckeraufnahme 12 des rechten Busgliedes 6. Die Leistungsbuchsenaufnahme 7 und die Datenbuchsenaufnahme 8 sind jeweils in die korrespondierenden Steckeraufnahmen 11 und 12 in Längsrichtung der Tragschiene 2 einsteckbar. Dabei werden Leistungsstecker 16 und Datenstecker 17, welche in den Steckeraufnahmen 11 und 12 angeordnet sind, jeweils in korrespondierende Leistungskontaktbuchsen 18 und Datenkontaktbuchsen 19 (siehe Figur 5), welche in den Buchsenaufnahmen 7 und 8 angeordnet sind, eingeführt und stellen untereinander jeweils elektrisch leitende Kontakte her.

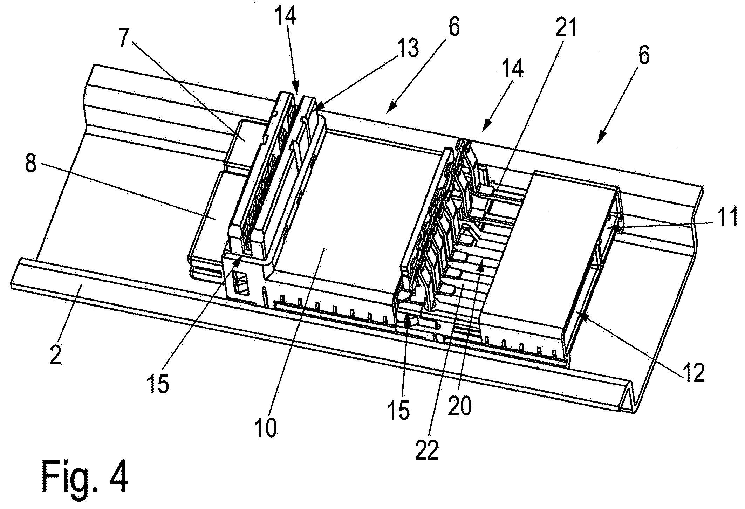

Der Steckplatz 5 eines Busglieds 6 ist durch gegenüberliegende Modulsteckaufnahmewände 13, die mit dem Gehäuse 10 verbunden sind, und dazwischen liegenden Modulkontaktbuchsen 14 und 15 (siehe Figur 4 und 5) gebildet.

Die Modulsteckaufnahmewände 13 sind hier mit nicht näher beschriebenen Führungen versehen, welche eine eindeutige Zuordnung des Modulsteckabschnitts 9 zu den Modulkontaktbuchsen 14 und 15 sicherstellen.

Figur 4 illustriert eine perspektivische, teilweise offene Ansicht der verbundenen Busglieder 6 nach Figur 2. Dabei ist ein Teil des Gehäuses 10 des rechten Busglieds 6 im Bereich der Modulkontaktbuchsen 14 und 15 entfernt. Die Modulkontaktbuchsen 14 und 15 sind in Modulleistungskontaktbuchsen 14 und Moduldatenkontaktbuchse 15 aufgeteilt. Die Modulleistungskontaktbuchsen 14 stehen mit Kontaktstiften 21 in Verbindung, und die Moduldatenkontaktbuchsen 15 sind mit einer Leiterplatte 22 verbunden. Ein solcher Busgliedleiteraufbau 20 wird nun im Zusammenhang mit Figur 5 beschrieben.

Figur 5 zeigt eine perspektivische Darstellung des Busgliedleiteraufbaus 20 des Busglieds 6 nach Figur 2.

Der Busgliedleiteraufbau 20, der in dem Gehäuse 10 angeordnet ist, weist die Leiterplatte 22 auf, welche sich in Längsrichtung des Gehäuses 10 und somit in Längsrichtung der Tragschiene 2 erstreckt. Neben der Leiterplatte 22 sind hier zwei Kontaktstifte 21 angeordnet, die sich in der Ebene der Leiterplatte 22 parallel zu dieser erstrecken. Die Leiterplatte 22 ist mit Leiterbahnen 23 versehen, die sich in der Längsrichtung der Leiterplatte 22 von einer Kontaktelementseite 25 (hier links) zu einer Steckkante 24 der Leiterplatte 22 erstrecken. Dabei bildet die Steckkante 24 mit den darauf befindlichen Endabschnitten der Leiterbahnen 23 die Datenstecker 17. Selbstverständlich kann die Leiterplatte 22 auch doppelseitig mit Leiterbahnen 23 versehen sein. Auch Multilayer-Leiterplatten und Leiterplatten mit integrierten Bauteilen und/oder Stromschienen sind möglich. Die Leiterbahnen 23 weisen eine übliche Dicke aus Kupfer auf, z.B. 35 $\mu$m oder 70 $\mu$m, und sind zur elektrischen Leitung von relativ geringen Stromstärken, z.B. für Datenübertragung und/oder Steuersignale, vorgesehen.

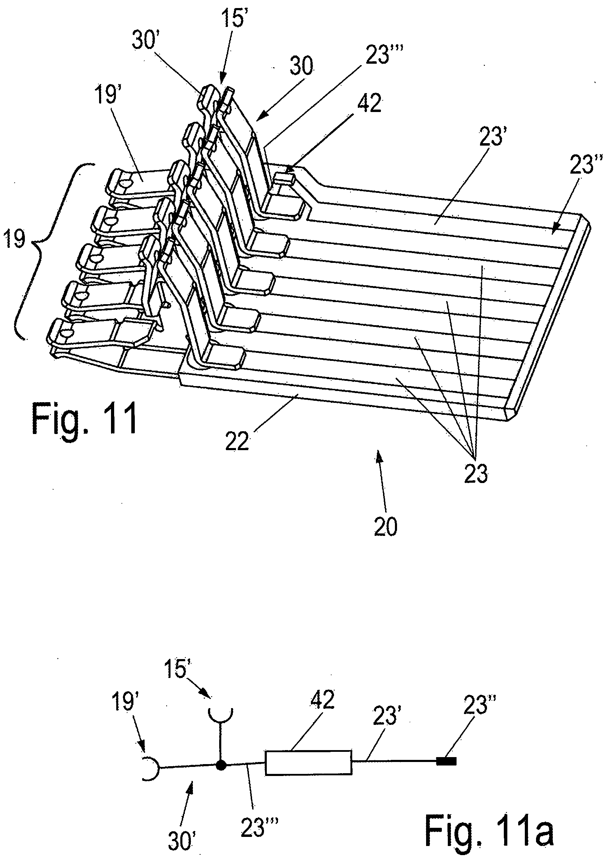

An der Kontaktelementseite 25 ist jeweils pro Leiterbahn 23 ein Doppel-Buchsenkontaktelement 30 angeordnet und mit einer korrespondierenden Leiterbahn 23 über einen Verbindungsabschnitt 26 elektrisch verbunden, z.B. verlötet. In diesem Beispiel sind fünf Doppel-Buchsenkontaktelemente 30 nebeneinander quer zur Längsrichtung der Leiterplatte 22 angebracht. Ein bestimmter Abschnitt eines jeden Doppelkontaktelementes 30 kann auch mechanisch mit der Leiterplatte 22 auf deren Unterseite verbunden (siehe auch Figur 11), z.B. geklebt oder ebenfalls gelötet (bei doppelseitiger Platinenbeschichtung) sein.

Die Kontaktstifte 21 bestehen aus einem massiven Metallwerkstoff, z.B. einer Kupferlegierung oder Kupfer, und sind zur elektrischen Leistungsübertragung, z.B. mit Stromstärken im Bereich von 1 bis 2 A vorgesehen. Sie weisen an der rechten Seite Spitzen 28 auf, die neben der Steckkante 17 liegen und die Leistungsstecker 16 bilden. An ihren anderen, hier linken, Ende sind die Kontaktstifte 21 ebenfalls wie die Leiterplatte 22 jeweils mit einem Doppel-Buchsenkontaktelement 30 in Leistungsverbindungsabschnitten 27 verbunden.

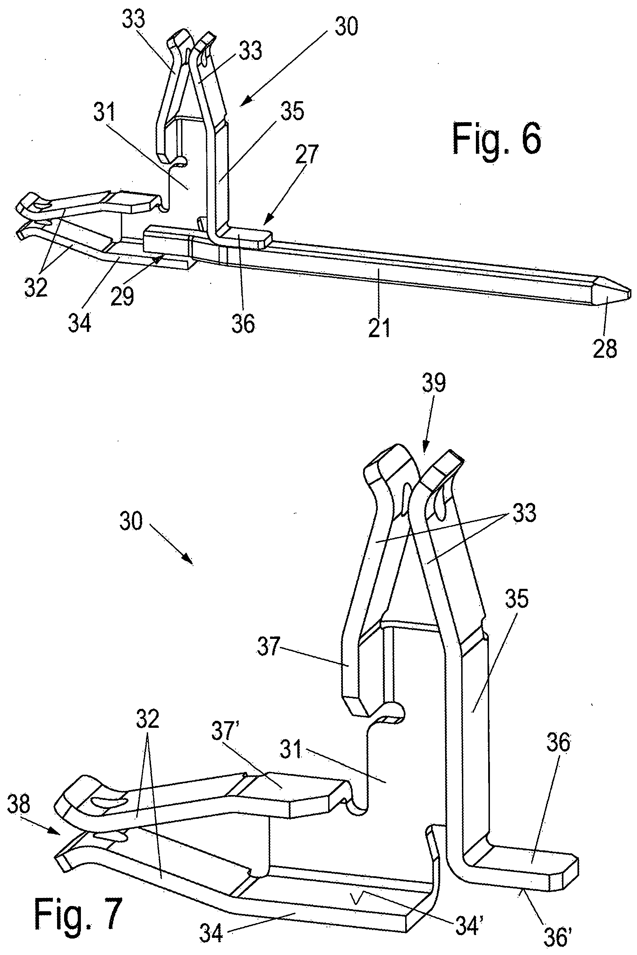

Hierzu zeigt Figur 6 eine perspektivische Darstellung eines Kontaktstifts 21 mit einem Doppel-Buchsenkontaktelement 30. Das Doppel-Buchsenkontaktelement 30 weist erste und zweite Kontaktzungen 32, 33 auf, die unten noch näher erläutert werden und an einem Grundkörper 31 angebracht bzw. mit diesem verbunden sind. Im Leistungsverbindungsabschnitt 27 auf der Oberseite des linken Endbereiches des Kontaktstifts 21 ist das Doppel-Buchsenkontaktelement 30 mit einem Fuß 36, welcher in Verlängerung einer zweiten Kontaktzunge 33 in Längsrichtung des Kontaktstifts 21 umgebogen ist, angebracht, z.B. geschweißt. An der Rückseite des linken Endes des Kontaktstifts 21 ist das Doppel-Buchsenkontaktelement 30 mit einem Kontaktverbindungsabschnitt 29, der sich auf dem Grundkörper 31 bzw. einem Bodenabschnitt 34 des Doppel-Buchsenkontaktelementes 30 befindet, ebenfalls in gleicher oder ähnlicher Weise wie der Fuß 36 angebracht, z.B. geschweißt.

Das Doppel-Buchsenkontaktelement 30 wird anhand einer perspektivischen Ansicht der Figur 7 weiter erläutert.

Das Doppel-Buchsenkontaktelement 30 ist zum Beispiel ein Stanzbiegeteil aus einem elektrischen leitenden Werkstoff mit Federeigenschaften im Bereich der ersten und zweiten Kontaktzungen 32, 33. Die Kontaktzungen 32 und 33 stehen sich jeweils in üblicher Weise gegenüber und sind vom Grundkörper 31 rechtwinklig umgebogen. Dabei bilden die ersten Kontaktzungen 32 einen ersten Buchsenabschnitt 38 mit sich benachbarten oder aufeinanderliegenden gerundeten Endabschnitten, der bei verbundenen Busgliedern 6 (siehe Figur 2 und 3) mit den Leiterbahnen 23 der Leiterplatte 22 oder den Abschnitten mit der Spitze 28 der Kontaktstifte 21 des anderen Busglieds 6 zusammengesteckt in Eingriff ist. Die untere erste Kontaktzunge 32 ist in Längsrichtung der Leiterplatte 22 (siehe Figur 5) bzw. des Kontaktstifts 21 (siehe Figur 6) zur Bildung des Bodenabschnitts 34 verlängert, an dessen rechtem Ende sich eine Verbindungsfläche 34' befindet, die den Kontaktverbindungsabschnitt 29 (siehe Figur 6) oder einen Verbindungsabschnitt zur Unterseite der Leiterplatte 22 (siehe Figur 5) bildet. Die gegenüberliegenden erste Kontaktzunge 32 ist mit einem Rand 37' verlängert, der parallel zum Bodenabschnitt 34 verläuft, aber nur ungefähr halb so lang ist.

Rechtwinklig zur den ersten Kontaktzungen 32, welche den ersten Buchsenabschnitt 38 bilden, sind die zweiten Kontaktzungen 33 ebenfalls am Grundkörper 31 umgekantet angeordnet und bilden einen zweiten Buchsenabschnitt 39. Hier ist die linke zweite Kontaktzunge 33 ähnlich zur oberen ersten Kontaktzunge 32 mit einem Rand 37 nach unten verlängert.

Die andere gegenüberliegende Kontaktzunge 33 erstreckt sich in einem Seitenabschnitt 35 nach unten und ist in den Fuß 36 umgebogen.

Der Fuß 36 wird mit einer Fußunterseite 36' an dem Kontaktstift 21 angebracht oder er wird derart an einer Leiterbahn 23 der Leiterplatte 22 angebracht.

Der zweite Buchsenabschnitt 39 ist zur Kontaktierung eines korrespondierenden Abschnittes, z.B. Leiterbahn oder Kontaktstift, des Modulsteckabschnitts 9 des Moduls 4 vorgesehen (siehe Figur 1). Die Buchsenabschnitte 38 bilden die Leistungskontaktbuchsen 18 und die Datenkontaktbuchsen 19 des Busgliedleiteraufbaus 20 gemäß Figur 5, wobei die Buchsenabschnitte 39 die Modulleistungskontaktbuchsen 14 und die Moduldatenkontaktbuchsen 15 des Busgliedleiteraufbaus 20 gemäß Figur 5 bilden.

Alle Doppel-Buchsenkontaktelemente 30 sind identisch.

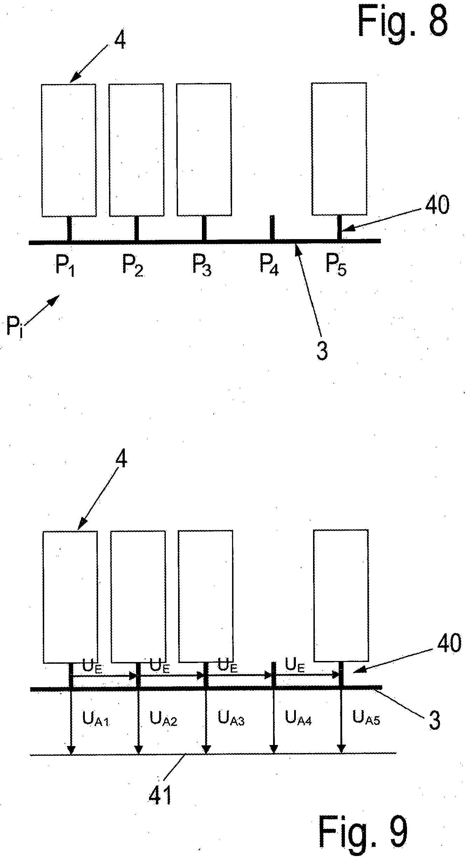

In einer weiteren Ausführung des Tragschienenbussystems 1 nach Figur 1 weist dieses eine Adressiereinrichtung 40 auf, welche im Zusammenhang mit Figur 8 beschrieben wird. Figur 8 zeigt eine Blockdarstellung eines Stationsbusses 3 mit Modulen 4. Die Module 4 sind über den Stationsbus 3 miteinander elektrisch verbunden.

Der Stationsbus 3, der auch als Backplan bezeichnet wird, verfügt über mehrere gleiche Steckplätze für einzelne Module 4. In diesem Beispiel sind fünf Positionen P1 bis P5 für diese Steckplätze gezeigt, wobei Position P4 nicht bestückt ist.

Damit die Module 4 eines Stationsbusses 3 (z.B. einer Station) miteinander kommunizieren können, benötigen sie eine Adresse, welche hier durch eine Adressiereinrichtung 40, die unten näher beschrieben wird, vorgegeben ist.

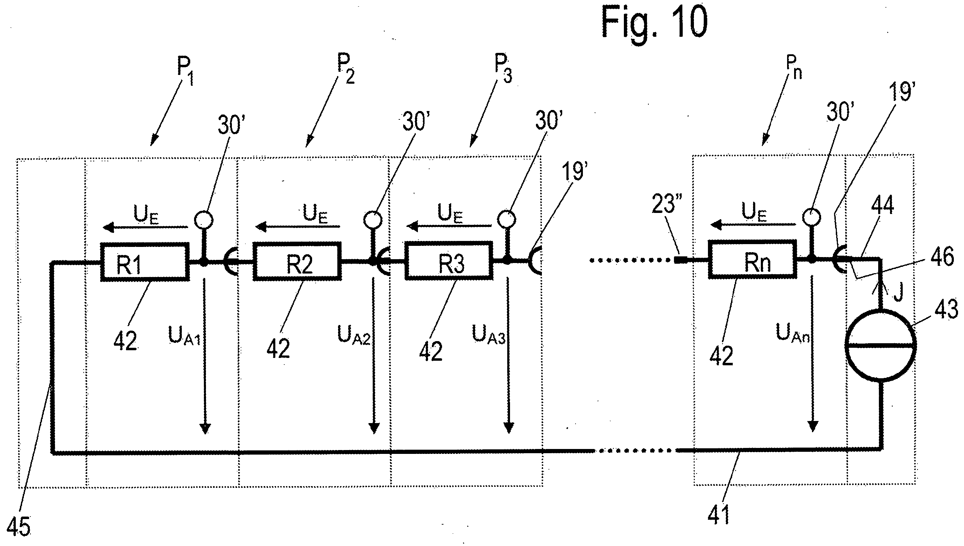

Figur 9 zeigt die Blockdarstellung des Stationsbusses 3 mit Modulen 4 nach Figur 8 mit Spannungsangaben zur Erläuterung des Prinzips der Adressiereinrichtung 40. Eine Adresse wird als ein analoger Spannungswert an jeweiligen Adressabgriffen 30' (siehe Figur 10) den zugehörigen Modulen 4 zur Verfügung gestellt. Jedes Modul 4 ermittelt eine ihm zugehörige Adressspannung UA zu einer gemeinsamen Rückleitung 41 und kann seine Adresse als Vielfaches einer Einzelspannung UE, welche zwischen benachbarten Adressabgriffen 30' anliegt, ermitteln. Dabei gilt, dass alle Einzelspannungen UE pro Modul 4 gleich groß sind. Dann ergibt sich die Adresse zu:

$$\text{Adresse} = UA/UE \qquad\qquad (1)$$

Wobei gilt: UE = I x R, wie weiter unten noch näher erläutert wird.

Hierzu zeigt Figur 10 ein Schaltbild einer Adressiereinrichtung 40 des Stationsbusses 3 mit Modulen 4 nach Figur 8.

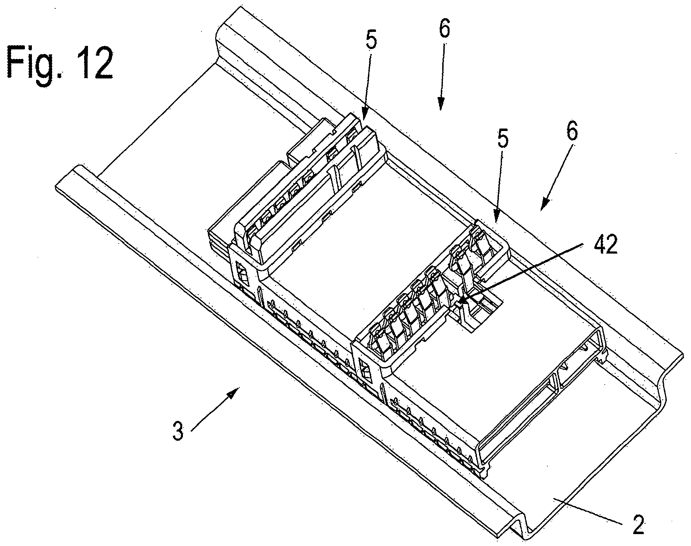

Es sind n Steckplätze mit Positionen P1 bis Pn gezeigt. An jeder Position Pi ist ein Adressenelement 42 angeordnet. Das bedeutet, jedes Busglied 6 an einer entsprechenden Position Pi ist mit einem solchen Adressenelement 42 ausgerüstet. In diesem Beispiel ist das Adressenelement 42 ein Widerstand R (R1 bis Rn). Diese Widerstände R1 bis Rn sind elektrisch in Reihe geschaltet, wobei sie über eine Zuleitung 44 über einen Zuleitungsstecker 46 mit einem Pol einer Konstantstromquelle 43, die einen konstanten Strom I liefert, verbunden sind. Der andere Pol der Konstantstromquelle 43 ist mit der Rückleitung 41 über eine Brücke 45 mit dem anderen Ende der Reihenschaltung der Widerstände R1 bis Rn verbunden. Jeder Steckplatz des Stationsbusses 3 ist ein Busglied 6 mit einer Adressierbuchse 19' und einem Leiterbahnabschnitt 23" (siehe Figuren 11 und 12). Die Adressierbuchse 19' ist mit dem Adressabgriff 30' verbunden. Somit ist die Einzelspannung UE hier zwischen dem Adressabgriff 30' und dem Leiterbahnabschnitt 23" bzw. über dem jeweiligen Widerstand Ri abgreifbar. Die jeweilige Adressspannung UA ist zwischen dem Adressabgriff 30' und der Rückleitung 41 ermittelbar. Die Rückleitung 41 wird über eine Leiterbahn 23 geführt.

Durch die Konstantstromquelle 43 wird sichergestellt, dass immer der vorab definierte Strom I mit hinreichender Genauigkeit durch die Reihenschaltung der Widerstände R1 bis Rn, die einen Spannungsteiler bilden, fließt. Bei gleichen Widerstandswerten der Widerstände R1 bis Rn und gleichem Strom ist UE jeweils gleich groß:

$$UE = Ri \times I \qquad\qquad (2)$$

$$UAi = Ri \times i \times I \qquad\qquad (3)$$

Beispiel:

Mit:

I = 1 mA, Ri = 1,0 k$\Omega$ und i=10 (10 Steckplätze)

ergibt sich UE zu 1 V. Aus (1), (2) und (3) ergeben sich folgende Adressen für die Positionen P1 bis P10 gemäß Tabelle 1:

Tabelle 1

| Position | UA [V] | UE [V] | Adresse |
|----------|--------|--------|---------|
| P1 | 1 | 1 | 1 |
| P2 | 2 | 1 | 2 |
| P3 | 3 | 1 | 3 |
| P4 | 4 | 1 | 4 |
| P5 | 5 | 1 | 5 |
| P6 | 6 | 1 | 6 |
| P7 | 7 | 1 | 7 |
| P8 | 8 | 1 | 8 |
| P9 | 9 | 1 | 9 |
| P10 | 10 | 1 | 10 |

Figur 11 zeigt eine perspektivische Darstellung des Busgliedleiteraufbaus 20 nach Figur 5 mit einem Bestandteil der Adressiereinrichtung 40 nach Figur 10. Und Figur 11a illustriert ein Schaltbild des Bestandteils der Adressiereinrichtung 40 des Busgliedleiteraufbaus 20 nach Figur 11.

Der Leiterbahnabschnitt 23" der Leiterplatte 22 bildet den Steckabschnitt zum nächsten Busglied 6 oder zur Brücke 45 (siehe Figur 10). Die Leiterbahn 23' verbindet den Steckabschnitt mit dem Adressenelement 42, das hier als Widerstand in SMD-Bauweise ausgebildet und auf der Leiterplatte 22 aufgebracht ist. Der Widerstand bzw. das Adressenelement 42 ist dann über einen weiteren Leiterbahnabschnitt 23'" mit dem Adressabgriff 30' (Doppel-Buchsenkontaktbauelement) in Gestalt einer Moduladressbuchse 15' und der Adressierbuchse 19' verbunden. Die Rückleitung 41 und die Brücke 45 sind nicht gezeigt, aber leicht vorstellbar, indem die Rückleitung 41 eine weitere Leiterbahn 23 ist und die Brücke 45 an den Datenkontaktbuchsen 19 eine Busglieds 6 an einem Ende des Stationsbusses 3 eingesteckt ist. An dem anderen Ende des Stationsbusses 3 ist die Konstantstromquelle 43 angeschlossen.

Figur 12 zeigt eine perspektivische, teilweise offene Ansicht der verbundenen Busglieder 6 nach Figur 4 mit dem Busgliedleiteraufbau 20 nach Figur 10. Es ist deutlich erkennbar, dass das Adressenelement 42 in Gestalt eines SMD-Bauteils nur sehr wenig Platz beansprucht und in dem Busgliedleiteraufbau 20 eines Busglieds 6 angeordnet ist. Wenn die Leiterplatte 22 eine gedruckte Schaltung ist, kann das Adressenelement 42 bei der Herstellung des Leiterplattenlayouts mit einbezogen werden.

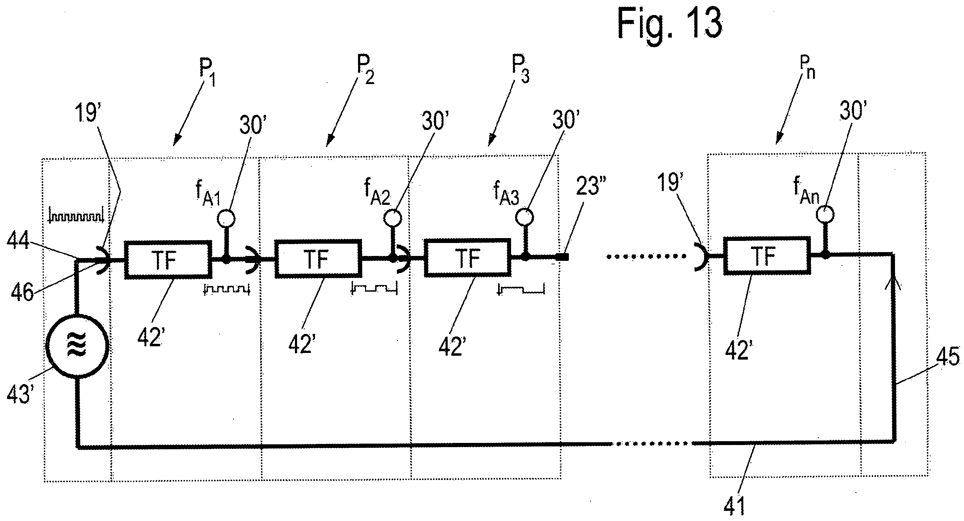

Schließlich zeigt Figur 13 ein Schaltbild einer weiteren Adressiereinrichtung des Stationsbusses mit Modulen nach Figur 8.

Figur 13 ist ähnlich der Figur 10 aufgebaut. So werden nur die Unterschiede erläutert. Ein Frequenzgenerator 43' liefert ein Signal mit einer vorher festlegbaren, konstanten Frequenz f, zum Beispiel ein digitales Rechtecksignal, das in der Figur 13 nur angedeutet ist. Der Frequenzbereich der Frequenz f ist so angepasst, dass eine zuverlässige und störungsfreie Adressierung möglich ist, zum Beispiel kann die Frequenz im Bereich 4 MHz liegen. Als Adresselemente 42' werden hier Frequenzteilereinrichtungen eingesetzt, die jeweils einen bestimmten Teilerfaktor TF aufweisen, zum Beispiel TF=1/2. Das heißt, dass die im Zuleitungsstecker 46 eingespeiste Frequenz f am Adressabgriff 30' mit dem Teilerfaktor TF multipliziert als Adressfrequenz fA1 die halbe Frequenz f beträgt (Beispiel: f=4MHz; TF=1/2; fA1 =2MHz). An den weiteren Adressabgriffen 30' steht dann fortlaufend jeweils die halbe Frequenz der jeweiligen Eingangsfrequenz als Adressfrequenz fA1 an. Mit anderen Worten, die Pulszeit der Rechtecksignale wird je Stufe verdoppelt.

Somit ergeben sich folgende Adressen für die Positionen P1 bis P10 gemäß Tabelle 2

Tabelle 2

| Position | Vom Modul messbare Frequenz [kHz] | Adresse |
|----------|-----------------------------------|---------|
| P1 | 2000,00000 | 1 |
| P2 | 1000,00000 | 2 |
| P3 | 500,00000 | 3 |
| P4 | 250,00000 | 4 |

(fortgesetzt)

| Position | Vom Modul messbare Frequenz [kHz] | Adresse |
|----------|-----------------------------------|---------|
| P5 | 125,00000 | 5 |
| P6 | 62,50000 | 6 |
| P7 | 31,25000 | 7 |
| P8 | 15,62500 | 8 |
| P9 | 7,81250 | 9 |
| P10 | 3,90625 | 10 |

Dabei ist es besonders vorteilhaft, dass das jeweilige Signal der zugehörigen Adressfrequenz fAn digital auswertbar ist, z.B. durch einen Mikrokontroller. Damit ist eine hohe Störsicherheit und Zuverlässigkeit der Adresserkennung möglich.

Die Erfindung ist nicht auf das oben erläuterte Ausführungsbeispiel beschränkt. Sie ist im Rahmen der angefügten Ansprüche modifizierbar.

Es ist zum Beispiel denkbar, dass anstelle der Leiterplatte 22 ein Leitergitter verwendet wird. Die Abschnitte der Leiterbahnen 23 im Bereich der Steckkante 24 können zur besseren Kontaktierung, d.h. zur Verringerung eines Übergangskontaktwiderstands, versilbert oder vergoldet sein. Dies kann auch bei den Kontaktstiften 21 im Bereich der Spitzen 28 der Fall sein.

Das Adressenelement 42 kann auch ein anderes elektronisches Bauteil, zum Beispiel ein Kondensator, eine Induktivität oder auch ein aktives Bauelement, beispielsweise eine Diode oder Zenerdiode, sein.

Außerdem kann die beschriebene Adressleitung (analog wie auch digital) zur Signalisierung eines Sammelfehlers genutzt werden. Geeignete Verfahren hierzu sind bei resistiver Adressierung (Adressiereinrichtung nach Figur 10) beispielhaft periodisches Kurzschließen des Adresssignals zu 0 V, d.h. der Adressabgriff 30' wird mit der Rückleitung 41 verbunden, wobei jedoch eine Beschädigung der Konstantstromquelle 43 oder des Frequenzgenerators 43' ausgeschlossen ist. Dieses periodische Signal setzt sich dann als Spannungsänderung in allen Busgliedern fort. Bei einer digitalen Adressierung, wie bei der weiteren Adressiereinrichtung nach Figur 13, erfolgt die Fehlermeldung durch Kurzschließen des Digitalsignals durch einen Busteilnehmer. Die Busglieder müssen sicherstellen, dass dieser Kurzschluss in beide Richtungen weitergegeben und somit kein Adressierungssignal mehr erzeugt wird.

Ein Vorgang des Adressierens bzw. einer Adresserkennung kann auch nur in einem vorbestimmten Zeitintervall durchgeführt werden.

**Bezugszeichen**

1 Tragschienenbussystem
2 Tragschiene
3 Stationsbus
4 Modul
5 Steckplatz
6 Busglied
7 Leistungsbuchsenaufnahme
8 Datenbuchsenaufnahme
9 Modulsteckabschnitt
10 Gehäuse
11 Leistungssteckeraufnahme
12 Datensteckeraufnahme
13 Modulsteckaufnahmewand
14 Modulleistungsbuchsen
15 Moduldatenbuchsen
15' Moduladressbuchse
16 Leistungsstecker
17 Datenstecker
18 Leistungskontaktbuchsen

| | |
|---|---|
| 19 | Datenkontaktbuchsen |
| 19' | Adressierbuchse |
| 20 | Busgliedleiteraufbau |
| 21 | Kontaktstift |
| 22 | Leiterplatte |
| 23 | Leiterbahn |
| 23', 23", 23'" | Leiterbahnabschnitte |
| 24 | Steckkante |
| 25 | Kontaktelementseite |
| 26 | Verbindungsabschnitt |
| 27 | Leistungsverbindungsabschnitt |
| 28 | Spitze |
| 29 | Kontaktverbindungsabschnitt |
| 30 | Doppel-Buchsenkontaktelement |
| 30' | Adressabgriff |
| 31 | Grundkörper |
| 32 | Erste Kontaktzungen |
| 33 | Zweite Kontaktzungen |
| 34 | Bodenabschnitt |
| 34' | Verbindungsfläche |
| 35 | Seitenabschnitt |
| 36 | Fuß |
| 36' | Fußunterseite |
| 37,37' | Rand |
| 38 | Erster Buchsenabschnitt |
| 39 | Zweiter Buchsenabschnitt |
| 40 | Adressiereinrichtung |
| 41 | Rückleitung |
| 42, 42' | Adressenelement |
| 43 | Konstantstromquelle |
| 43' | Frequenzgenerator |
| 44 | Zuleitung |
| 45 | Brücke |
| 46 | Zuleitungsstecker |
| f | Frequenz |
| fA1...n | Adressfrequenz |
| I | Strom |
| P1...n | Position |
| R1...n | Widerstand |
| TF | Teilerfaktor |
| UE | Einzelspannung |
| UA1...n | Adressspannung |

**Patentansprüche**

1. Tragschienenbussystem (1),

A) mit einer Tragschiene (2) und einem in der Tragschiene (2) angeordneten Stationsbus (3), welcher mindestens zwei verbindbare Busglieder (6) zur Verbindung mit jeweils einem zuzuordnenden Modul (4) als Busteilnehmer aufweist,
**dadurch gekennzeichnet, dass**
B) jedes Busglied (6) Kontaktstifte (21) zur Übertragung elektrischer Versorgungsleistung und mindestens eine Leiterplatte (22) mit Leiterbahnen (23) zur Übertragung elektrischer Daten- und/oder Steuersignale geringerer Leistung als die Versorgungsleistung aufweist, und
C) jeder Kontaktstift (21) und jede Leiterbahn (23) der Leiterplatte (22) mit jeweils einem Doppel-Buchsenkontaktelement (30) verbunden ist,
D) dass das Doppel-Buchsenkontaktelement (30) einen Fuß (36) und eine dem Fuß (36) gegenüberliegend angeordnete Verbindungsfläche (34') aufweist, und

E) dass jeder Fuß (36) mit seiner Fußunterseite (36') an dem Kontaktstift (21) angebracht ist,

oder

dass er mit seiner Fußunterseite (36') an einer Leiterbahn (23) der Leiterplatte (22) angebracht ist.

2. Tragschienenbussystem (1) nach Anspruch 1, **dadurch gekennzeichnet, dass** das Doppelbuchsenkontaktelement (30) sowohl zur Übertragung elektrischer Versorgungsleistung als auch zur Übertragung elektrischer Daten- und/oder Steuersignale geringerer Leistung ausgebildet ist.

3. Tragschienenbussystem (1) nach einem der vorhergehenden Ansprüche, **dadurch gekennzeichnet, dass** das Doppel-Buchsenkontaktelement (30) erste Buchsenabschnitte (38) zur Verbindung der Kontaktstifte (21) und Leiterbahnen (23) der Leiterplatte (22) und zweite Buchsenabschnitte (39) aufweist, welche mit den ersten Buchsenabschnitten (38) elektrisch und mechanisch verbunden sind und zum elektrischen Anschluss eines zuzuordnenden Moduls (4) als Busteilnehmer vorgesehen sind.

4. Tragschienenbussystem (1) nach Anspruch 3, **dadurch gekennzeichnet, dass** die zweiten Buchsenabschnitte (39) des Doppel-Buchsenkontaktelementes (30) im Wesentlichen senkrecht zu den ersten Buchsenabschnitten (38), die sich in Längsrichtung der Tragschiene (2) erstrecken, angeordnet sind.

5. Tragschienenbussystem (1) nach einem der vorhergehenden Ansprüche, **dadurch gekennzeichnet, dass** sich die Kontaktstifte (21) und die Leiterplatte (23) in jedem Busglied (6) nebeneinander angeordnet in Längsrichtung der Tragschiene (2) erstrecken.

6. Tragschienenbussystem (1), nach einem der Ansprüche 1 bis 5, mit einer Tragschiene (2) und einem Stationsbus (3), welcher mindestens zwei verbindbare Busglieder (6) zur Verbindung mit jeweils einem zuzuordnenden Modul (4) als Busteilnehmer aufweist, wobei der Stationsbus (3) mit einer Adressierungseinrichtung (40) versehen ist, welche mindestens ein Adressenelement (42,42') in jedem Busglied (6) und eine gemeinsame elektrische Stromversorgung oder Signalversorgung der Adressenelemente (42, 42') umfasst.

7. Tragschienenbussystem (1) nach Anspruch 6, **dadurch gekennzeichnet, dass** die Adressenelemente (42') zur digitalen Manipulation eines Signals ausgebildet sind.

8. Tragschienenbussystem (1) nach Anspruch 7, **dadurch gekennzeichnet, dass** die Adressenelemente (42') als Frequenzteilereinrichtungen ausgebildet sind.

9. Tragschienenbussystem (1) nach Anspruch 8, **dadurch gekennzeichnet, dass** die Adressenelemente (42') als Frequenzteilereinrichtungen einen jeweiligen vorbestimmten Teilerfaktor (TF) aufweisen.

10. Tragschienenbussystem (1) nach Anspruch 8 oder 9, **dadurch gekennzeichnet, dass** die gemeinsame elektrische Signalversorgung der Adressenelemente (42') einen Frequenzgenerator (43') umfasst.

11. Tragschienenbussystem (1) nach Anspruch 10, **dadurch gekennzeichnet, dass** eine Adresse jedes der mindestens zwei Busglieder (6) durch eine Adressfrequenz (fAn) festgelegt ist, welche durch Beaufschlagung einer Frequenz (f) des Frequenzgenerators (43') mit vorbestimmten Teilerfaktoren (TF) erzeugt ist.

12. Verfahren zum Adressieren von Busgliedern eines Bussystems, **dadurch gekennzeichnet, dass** das Adressieren mit einem Bussystem nach einem der Ansprüche 7 bis 11 erfolgt.

13. Verfahren nach Anspruch 12, **dadurch gekennzeichnet, dass** das Adressieren während eines vorher festlegbaren Zeitintervalls durchgeführt wird und/oder dass das Signalisieren mit einer Adressiereinrichtung eines Bussystems nach einem der Ansprüche 7 bis 11 durch geeignete Manipulation eines Adressabgriffs, beispielsweise durch periodisches Kurzschließen, erfolgt.

**Claims**

1. Mounting rail bus system (1),

A) with a mounting rail (2) and a station bus (3), which is arranged in mounting rail (2) and which has at least two connectable bus members (6) for connection with in each case a module (4) that is to be associated as bus partner,

**characterized in that**

B) each bus member (6) has contact pins (21) for the transmission of electrical power supply output and at least one printed circuit board (22) with strip conductors (23) for the transmission of electrical data and/or control signals that have a lesser power output than the supply power output, and

C) each contact pin (21) and each strip conductor (23) of the printed circuit board (22) is connected in each case with a double bushing contact element (30)

D) the double bushing contact element (30) has a foot (36) and a connecting surface (34') that is arranged opposite the foot (36) and

E) each foot (36) is attached to the contact pin (21) with its foot underside (36') or that it is attached with its foot underside (36') on a strip conductor (23) of printed circuit board (22).

2.  Mounting rail bus system (1) according to Claim 1, **characterized in that** the double bushing contact element (30) is made both for the transmission of electrical power supply output and for the transmission of electrical data and/or control signals having a lesser power output.

3.  Mounting rail bus system (1) according to one of the above claims, **characterized in that** the double bushing contact element (30) has first bushing segments (38) for the connection of the contact pins (21) and the strip conductors (23) of the printed circuit board (22) and second bushing segments (39), which are electrically and mechanically connected with the first bushing segments (38) and which are provided for the electrical conduction of an allocable module (4) as bushing partner.

4.  Mounting rail bus system (1) according to Claim 3, **characterized in that** the second bushing segments (39) of the double bushing contact element (30) are arranged essentially perpendicularly with respect to the first bushing segments (38) that extend in the longitudinal direction of the mounting rail (2).

5.  Mounting rail bus system (1) according to one of the above claims, **characterized in that** the contact pins (21) and the printed circuit board (23) extend in each bus member (6) arranged next to each other in the longitudinal direction of the mounting rail (2).

6.  Mounting rail bus system (1), according to one of Claims 1 to 5 with a mounting rail (2) and a station bus (3), which has at least two connectable bushing members (6) for connection with in each case an allocable module (4) as bus partner, whereby the station bus (3) is provided with an addressing device (4) that comprises at least one address element (42, 423') in each bus member (6) and a common electric power supply or signal supply of the address elements (42, 42').

7.  Mounting rail bus system (1) according to Claim 6, **characterized in that** the address elements (42') are made for the digital manipulation of a signal.

8.  Mounting rail bus system (1) according to Claim 7, **characterized in that** the address elements (42') are made as frequency divider devices.

9.  Mounting rail bus system (1) according to Claim 8, **characterized in that** the address elements (42') as frequency divider devices have a particular predetermined divider factor (TF).

10. Mounting rail bus system (1) according to Claim 8 or 9, **characterized in that** the common electrical signal supply of the address elements (42') comprises a frequency generator (43').

11. Mounting rail bus system (1) according to Claim 10, **characterized in that** an address of each of at least two bus members (6) is determined by an address frequency (FAn) that is generated by the impacting of a frequency (f) of the frequency generator (43') with predetermined divider factors (TF).

12. Process for the addressing of bus members of a bus system, **characterized in that** the addressing is done with a bus system according to one of Claims 7 to 11.

13. Process according to Claim 12, **characterized in that** the addressing is done during a predetermined time interval and/or that the signaling is done with an addressing device of a bus system according to one of Claims 7 to 11 by suitable manipulation of an address tap, for example, by periodic short-circuiting.

**Revendications**

1. Système de bus sur rail porteur (1),

   A) avec un rail porteur (2) et un bus à stations (3) disposé sur le rail porteur (2) et possédant au moins deux éléments de bus (6) qui peuvent être connectés en vue de la liaison avec un module (4) associé à chacun constituant un appareil connecté au bus,
   **caractérisé en ce que**
   B) chaque élément du bus (6) présente des broches de contact (21) pour la transmission d'une puissance d'alimentation électrique et au moins une carte de circuits imprimés (22) avec des pistes conductrices (23) pour la transmission de signaux électriques de données et/ou de commande d'une puissance plus faible que la puissance d'alimentation, et
   C) chaque broche de contact (21) et chaque piste conductrice (23) des cartes de circuits imprimés (22) est connectée à un élément de contact à double douille (30),
   D) **en ce que** l'élément de contact à double douille (30) possède un pied (36) et une surface de connexion (34') faisant face au pied (36) et
   E) **en ce que** chaque pied (36) est disposé avec sa face inférieure de pied (36') sur la broche de contact (21),

   ou

   **en ce qu'**il est disposé avec sa face inférieure de pied (36') sur une piste conductrice (23) des cartes de circuits imprimés (22).

2. Système de bus sur rail porteur (1) selon la revendication 1, **caractérisé en ce que** l'élément de contact à double douille (30) est conçu aussi bien pour la transmission de la puissance d'alimentation électrique que pour celle de signaux électriques de données et/ou de commande de plus faible puissance.

3. Système de bus sur rail porteur (1) selon l'une des revendications précédentes, **caractérisé en ce que** l'élément de contact à double douille (30) présente des premières parties de douille (38) pour la connexion des broches de contact (21) et des pistes conductrices (23) des cartes de circuits imprimés (22) et des deuxièmes parties de douille (39) qui sont reliées électriquement et mécaniquement aux premières parties de douille (38) et sont prévues pour le raccordement électrique d'un module (4) associé constituant un appareil connecté au bus.

4. Système de bus sur rail porteur (1) selon la revendication 3, **caractérisé en ce que** les deuxièmes parties de douille (39) de l'élément de contact à double douille (30) sont disposées de façon sensiblement perpendiculaire aux premières parties de douille (38), qui s'étendent dans le sens de la longueur du rail porteur (2).

5. Système de bus sur rail porteur (1) selon l'une des revendications précédentes, **caractérisé en ce que** les broches de contact (21) et les cartes de circuits imprimés (23) sont disposées les unes à côté des autres dans chaque élément de bus (6) et s'étendent dans le sens de la longueur du rail porteur (2).

6. Système de bus sur rail porteur (1) selon l'une des revendications 1 à 5, avec un rail porteur (2) et un bus à stations (3) possédant au moins deux éléments de bus (6) qui peuvent être connectés en vue de la liaison avec un module (4) associé à chacun constituant un appareil connecté au bus, dans lequel le bus à stations (3) est muni d'un dispositif d'adressage (40) qui comprend au moins un élément d'adresse (42, 42') dans chaque élément de bus (6) et une alimentation commune en courant électrique ou en signaux électriques des éléments d'adresse (42, 42').

7. Système de bus sur rail porteur (1) selon la revendication 6, **caractérisé en ce que** les éléments d'adresse (42') sont conçus en vue de la manipulation numérique d'un signal.

8. Système de bus sur rail porteur (1) selon la revendication 7, **caractérisé en ce que** les éléments d'adresse (42') sont conçus comme des dispositifs diviseurs de fréquence.

9. Système de bus sur rail porteur (1) selon la revendication 8, **caractérisé en ce que** les éléments d'adresse (42') servant de dispositifs diviseurs de fréquence présentent chacun un facteur de division (TF) prédéterminé.

**10.** Système de bus sur rail porteur (1) selon la revendication 8 ou 9, **caractérisé en ce que** l'alimentation commune en signaux électriques des éléments d'adresse (42') comprend un générateur de fréquences (43').

**11.** Système de bus sur rail porteur (1) selon la revendication 10, **caractérisé en ce qu'**une adresse de chacun des au moins deux éléments de bus (6) est définie par une fréquence d'adresse (fAn) qui est produite en appliquant à une fréquence (f) du générateur de fréquences (43') des facteurs de division (TF) prédéterminés.

**12.** Procédé pour l'adressage d'éléments de bus d'un système de bus, **caractérisé en ce que** l'adressage est réalisé avec un système de bus selon l'une des revendications 7 à 11.

**13.** Procédé selon la revendication 12, **caractérisé en ce que** l'adressage est effectué pendant un intervalle de temps pouvant être déterminé au préalable et/ou en ce que la signalisation est réalisée avec un dispositif d'adressage d'un système de bus selon l'une des revendications 7 à 11 par une manipulation appropriée d'une prise d'adresse, par exemple par un court-circuit périodique.

# Fig. 1

## Fig. 2

Fig. 4

Fig. 5

Fig. 6

Fig. 7

# Fig. 8

# Fig. 9

Fig. 10

30' 15'

19' 30 23''''

42

19 23'

23''

22

23

20

# Fig. 11

15'

19' 42 23''

23'

30' 23'''' # Fig. 11a

Fig. 12

Fig. 13

EP 2 569 827 B1

**IN DER BESCHREIBUNG AUFGEFÜHRTE DOKUMENTE**

**In der Beschreibung aufgeführte Patentdokumente**

- DE 29713960 U1